# EUROPÄISCHE PATENTSCHRIFT

(11) **EP 3 388 276 B1**
(45) Veröffentlichungstag und Bekanntmachung des Hinweises auf die Patenterteilung: **05.05.2021**
(21) Anmeldenummer: 18165571.3
(22) Anmeldetag: 04.04.2018
(51) Int. Cl.: B60K 35/00, B60K 37/06, G05G 1/02, G05G 1/08, G06F 3/041, G06F 3/01, H01H 19/00, H01H 19/54, H01H 13/00, H01H 15/00, H03K 17/96, H03K 17/965

(54) **BEDIENANORDNUNG ZUM BEDIENEN VON ZUMINDEST EINEM ELEKTRISCHEN GERÄT MIT EINEM KRAFTSENSOR, FAHRERASSISTENZSYSTEM, KRAFTFAHRZEUG SOWIE VERFAHREN ZUM BEDIENEN EINER BEDIENANORDNUNG**
OPERATING ARRANGEMENT FOR OPERATING AT LEAST ONE ELECTRICAL APPLIANCE WITH A FORCE SENSOR, DRIVER ASSISTANCE SYSTEM, MOTOR VEHICLE, AND METHOD OF OPERATING AN OPERATING ARRANGEMENT
DISPOSITIF DE COMMANDE D'AU MOINS UN APPAREIL ÉLECTRIQUE AU MOYEN D'UN CAPTEUR DE FORCE, SYSTÈME D'AIDE À LA CONDUITE, VÉHICULE AINSI QUE PROCÉDÉ DE COMMANDE D'UN DISPOSITIF DE COMMANDE

(30) Priorität: 06.04.2017 DE 102017107401
(43) Veröffentlichungstag der Anmeldung: 17.10.2018
(73) Patentinhaber: Valeo Schalter und Sensoren GmbH, 74321 Bietigheim-Bissingen (DE)
(72) Erfinder: Staude, Sascha, 74321 Bietigheim-Bissingen (DE)
(74) Vertreter: Pothmann, Karsten

(56) Entgegenhaltungen:
- FR-A1- 3 026 501
- US-A1- 2005 151 720
- US-A1- 2007 279 401
- US-A1- 2016 035 504
- US-A1- 2016 342 214

## Beschreibung

Die Erfindung betrifft eine Bedienanordnung zum Bedienen von zumindest einem elektrischen Gerät in einem Kraftfahrzeug. Die Bedienanordnung weist dabei ein Bedienelement auf, auf welches beim Betätigen des Bedienelements in eine erste Betätigungsrichtung eine Kraft durch eine Bedienperson ausübbar ist. Des Weiteren weist die Bedienanordnung einen Kraftsensor auf, mittels welchem die ausübbare Kraft erfassbar ist. Bei einem Überschreiten eines vorbestimmten ersten Kraft-Schwellwerts erzeugt die Bedienanordnung ein Schaltsignal zum Bedienen des elektrischen Geräts. Ferner betrifft die Erfindung ein Fahrerassistenzsystem mit einer Bedienanordnung sowie ein Kraftfahrzeug mit dem Fahrerassistenzsystem. Die Erfindung betrifft weiterhin ein Verfahren zum Bedienen einer Bedienanordnung von zumindest einem elektrischen Gerät in einem Kraftfahrzeug.

Aus dem Stand der Technik sind bereits Bedienanordnungen bekannt, welche über elektrische Kontakte verfügen und eine mechanische haptische Rückmeldung geben. Weiterhin sind aus dem derzeitigen Stand der Technik Bedienanordnungen bekannt, welche eine beziehungsweise zwei Schaltstufen zum Bedienen eines elektrischen Geräts aufweisen.

Die FR 3026501 offenbart eine haptische Rückkopplungsschnittstelle für ein Kraftfahrzeug mit einem magnetorheologischem Fluidmodul, um eine Widerstandskraft für den Benutzer zu erzeugen. Dabei ist ein Kraftsensor derart konfiguriert, die auf ein bewegliches Element ausgeübte Kraft zu messen und eine Verarbeitungseinheit ist derart konfiguriert, um ein Informationssignal zu erzeugen, das den Benutzer über das Vorhandensein eines nachfolgenden Befehls zu einem zuvor angezeigten Befehl als Funktion der gemessenen Kraft informieren soll.

Die US 2007/279401 A1 offenbart einen Drehknauf welcher über einen Schaft drehbar zu einer Grundplatte drehbar gelagert ist. Des Weiteren ist ein Sensor vorgesehen, welcher die Betätigung des Drehknaufes erkennen kann sowie eine Haptikeinheit, um eine haptische Rückmeldung am Knauf zu erzeugen. Die haptische Rückmeldung ist dabei elektronisch einstellbar.

Die US 2005/151720 A1 offenbart ein Verfahren zur Erzeugung einer haptischen Rückmeldung bei Bewegung eines Elements in eine erste Richtung von einer ersten in eine zweite Position, wobei die haptische Rückmeldung bei einer anschließenden Bewegung in eine zweite Richtung unterbrochen wird.

Die US 2016/342214 A1 offenbart eine Verfahren zur Erzeugung einer virtuellen Rastung mittels einer vibrierenden haptischen Rückmeldung, wobei ein Eingangssignal mit einer Betätigungsinformation empfangen wird und daraus ein Signal erzeugt wird, um einen Aktuator anzusteuern.

Die US 2016/035504 A1 offenbart eine Vorrichtung zur Bedienung mehrerer Funktionen in einem Kraftfahrzeug, mit einem Bedienelement, welches um eine Drehachse verschwenkbar gelagert ist und dadurch zwischen wenigstens zwei Positionen beweglich ist, wobei zumindest einer der Positionen eine Schaltfunktion zugeordnet ist, wobei das Bedienelement wenigstens zwei berührungssensitive kapazitive Sensorflächen aufweist, wobei durch eine manuelle Betätigung des Bedienelements in Abhängigkeit davon, welche der Sensorflächen berührt wird, unterschiedliche Funktionen ausgelöst werden, und wobei das Bedienelement beim Betätigen eine haptische Rückmeldung gibt, wobei Endabschnitte der Drehachse des Bedienelements an zwei seitlichen Lagerstellen in zwei entlang einer Hochachse ausgerichteten Langlochführungen gelagert sind, wobei die haptische Rückmeldung durch einen elektromagnetischen Aktuator erfolgt, welcher das Bedienelement in der Achsenrichtung der Drehachse temporär verschiebt, wobei das Bedienelement an einer mittleren Lagerstelle bezüglich der Richtung der Hochachse zentriert gelagert ist und wobei sich das Bedienelement auf den Gelenkzapfen von mindestens zwei Schwenkgelenken abstützt

Die DE 10 2010 031 926 A1 offenbart beispielsweise ein Eingabesteuergerät mit einem unteren neigbaren Element, das neigbar auf einer Basis abgestützt ist. Des Weiteren weist das Eingabesteuergerät ein oberes neigbares Element auf, das neigbar von dem unteren neigbaren Element abgestützt ist. Ein Bedienknopf, der an einem Stiftbereich des oberen neigbaren Elements befestigt und integral mit diesem neigbar ist, sowie ein Tastschalter, der Neigen des unteren neigbaren Elements erkennt, sind ebenfalls an dem Eingabesteuergerät mit angeordnet. Das Eingabesteuergerät weist weiterhin einen Kraftsensor auf, der das Neigen des oberen neigbaren Elements erkennt, wobei eine Steuereinrichtung, die auf der Basis eines Erkennungssignals ein vorgegebenes Steuersignal erzeugt, ebenfalls mit an dem Eingabesteuergerät angeordnet ist. Wenn der Bedienknopf in eine frei gewählte Richtung neigend betätigt wird, wird das obere neigbare Element von dem unteren neigbaren Element geneigt und der Kraftsensor gibt ein Analogsignal aus, das dem angewendeten Druck entspricht. Wenn der Bedienknopf so neigend betätigt wird, dass er einen vorgegebenen Neigungswinkel überschreitet, wird das untere neigbare Element integral mit dem oberen neigbaren Element geneigt und bewirkt, dass der Tastschalter ein Einschaltsignal ausgibt.

Des Weiteren offenbart die DE 10 2013 200 178 A1 einen elektrischen Schalter mit einer Doppelstromschaltung. Der Schalter mit der Doppelstromschaltung ist für die Betätigung von elektrischen Geräten ausgebildet, wobei der Schalter einen Deckel und ein Sockelteil, und eine Betätigungswippe, die mit dem Deckel verbunden ist, aufweist. Der Schalter ist mit dem Deckel derart verbunden, dass die vorstehend genannte Kippbewegung durchgeführt werden kann, wobei auf dem Sockelteil des Schaltergehäuses zumindest eine Leiterplatte für die Steuerung solcher elektrischer Geräte angebracht ist. Des Weiteren weist dieser Schalter eine Schalterbetätigungsvorrichtung mit einem Paar von Plättchen auf, die über entsprechende Scharniere mit einem Paar von Druckstangen verbunden sind. Diese Plättchen sind infolge der Betätigung der Betätigungswippe über die Druckstangen mit Druck beaufschlagt. Des Weiteren weist der Schalter eine unterhalb dieser Betätigungsvorrichtung angebrachte Silikonmatte mit Silikonblasenpaaren auf, die entsprechend dem Plättchen angeordnet sind und von diesen über den vorstehend erwähnten Druck beaufschlagt werden. Dieser Druck der Druckstangen wird an einer Stelle beaufschlagt, die nicht im gleichen Abstand zu den Ansatzpunkten der Wirkung der Silikonblasen auf den Plättchen ist, so dass die lineare Bewegung der nach unten gedrückten Druckstangen in eine Dreh-Schiebebewegung der Plättchen umgewandelt wird.

Als nachteilig hat sich hierbei gezeigt, dass zwischen den mechanisch beweglichen Teilen und dem statischen Teil des Schalters immer eine Lücke existiert. Dies hat zur Folge, dass die Lebenserwartung des Schalters aufgrund der mechanischen Beanspruchung limitiert ist. Des Weiteren kann durch die mechanische haptische Rückmeldung die Rückmeldung bereitgestellt werden, ohne dass das elektrische Gerät bedient wird. Mit anderen Worten kann eine Bedienperson eine haptische Rückmeldung für ein Bedienen eines elektrischen Geräts erhalten, wobei beispielsweise der Schalter defekt sein kann, und das elektrische Gerät aber nicht bedient wird, obwohl eine haptische Rückmeldung für die Bedienperson erzeugt wurde.

Aufgabe der vorliegenden Erfindung ist es, eine Bedienanordnung, ein Fahrerassistenzsystem, ein Kraftfahrzeug sowie ein Verfahren zum Bedienen einer Bedienanordnung aufzuzeigen, welches eine zuverlässigere haptische Rückmeldung an eine Bedienperson ermöglicht.

Diese Aufgabe wird erfindungsgemäß durch eine Bedienanordnung, durch ein Fahrerassistenzsystem, durch ein Kraftfahrzeug sowie ein Verfahren mit den Merkmalen gemäß den jeweiligen unabhängigen Ansprüchen gelöst.

Eine erfindungsgemäße Bedienanordnung zum Bedienen von zumindest einem elektrischen Gerät in einem Kraftfahrzeug umfasst ein Bedienelement, auf welches beim Betätigen des Bedienelements in eine erste Betätigungsrichtung eine Kraft durch eine Bedienperson ausübbar ist. Insbesondere ist das Bedienelement ausgehend von einer Grundstellung betrachtet in die Betätigungsrichtung betätigbar. Des Weiteren umfasst die Bedienanordnung einen Kraftsensor, mittels welchem die ausübbare Kraft erfassbar ist. Bei einem Überschreiten eines vorbestimmten ersten Kraft-Schwellwerts erzeugt die Bedienanordnung ein Schaltsignal zum Bedienen des elektrischen Geräts.

Ein wesentlicher Gedanke der Erfindung ist darin zu sehen, dass die Bedienanordnung einen Aktuator aufweist. Bei einem Überschreiten des ersten Kraft-Schwellwerts erzeugt eine Steuereinrichtung der Bedienanordnung ein Steuersignal an den Aktuator. Durch den Aktuator ist ein haptisches Signal zum haptischen Wahrnehmen durch die Bedienperson an dem Bedienelement erzeugbar. Insbesondere kann die Steuereinrichtung derart ausgebildet sein, dass das haptische Signal nur erzeugt wird, wenn das elektrische Gerät auch tatsächlich bedient wird. Somit kann gewährleistet werden, dass die Steuereinrichtung das Steuersignal für den Aktuator nur erzeugt, wenn auch das elektrische Gerät bedient wird. Somit kann besonders zuverlässig das haptische Signal für die Bedienperson nur dann ausgegeben werden, wenn auch das elektrische Gerät bedient ist. Insbesondere wenn die Bedienanordnung zum Bedienen von sicherheitsrelevanten elektrischen Geräten benutzt wird, kann somit erreicht werden, dass die Bedienperson zuverlässig und korrekt auch eine entsprechende Rückmeldung der Bedienanordnung des sicherheitsrelevanten elektrischen Geräts bekommt.

Insbesondere befindet sich die Bedienanordnung in der Grundstellung, wenn keine Kraft auf das Bedienelement ausgeübt wird. Insbesondere kann vorgesehen sein, dass bei einer Nichtbedienung der Bedienanordnung, die Bedienanordnung wieder automatisch in die Grundstellung geht. Die Nichtbedienung kann insbesondere als keine Kraftbeaufschlagung auf das Bedienelement gesehen werden.

In einer vorteilhaften Ausgestaltungsform kann das Bedienelement einen berührungsempfindlichen Sensor aufweisen. Insbesondere kann es sich bei dem berührungsempfindlichen Sensor um einen kapazitiven Sensor handeln. Mittels dieser Ausgestaltungsform kann ein Berühren der Bedienanordnung durch beispielsweise einen Finger der Bedienperson festgestellt werden. Insbesondere führt dies dazu, dass es bei einem ungewollten Berühren mit anderen Körperteilen nicht zu einem Bedienen des elektrischen Geräts kommt. Es kann beispielsweise die Steuereinrichtung derart angesteuert werden, dass sowohl der kapazitive Sensor ein Signal an die Steuereinrichtung geben muss, dass beispielsweise ein Finger auf dem berührungsempfindlichen Sensor liegt, als auch der erste Kraft-Schwellwert erreicht werden muss, um zu einem Bedienen des elektrischen Geräts zu gelangen. Bei dieser Ausgestaltungsform ist somit ein ungewolltes Bedienen des elektrischen Geräts vermeidbar, was zu einer größeren Sicherheit führt.

Ebenfalls möglich ist, dass die Bedienanordnung eine Mehrzahl an berührungsempfindlichen Sensoren aufweist, wobei bei einem Berühren eines jeweiligen berührungsempfindlichen Sensors eine jeweilige unterschiedliche Funktion des elektrischen Geräts und/oder ein jeweiliges unterschiedliches elektrische Gerät bedienbar ist. Mit anderen Worten können über die jeweiligen berührungsempfindlichen Sensoren unterschiedliche Funktionen des elektrischen Geräts und/oder unterschiedliche elektrischen Geräte bedient werden.

Gemäß einer vorteilhaften Ausgestaltungsform kann die Bedienanordnung als Aktuator einen Vibrationsmotor und/oder einen Linearmotor und/oder einen elektromagnetischen Aktuator und/oder einen piezoelektrischen Aktuator aufweisen. Insbesondere Vibrationsmotoren sind bereits aus dem Stand der Technik hinlänglich bekannt und robust und hochfunktionell. Mittels des Vibrationsmotors kann somit ein besonders zuverlässiger Aktuator zur Verfügung gestellt werden. Der Linearmotor bietet entsprechende Vorteile aufgrund seiner Konstruktion, da er weniger reibende Teile in dem Linearmotor aufweist, wodurch die Lebensdauer des Aktuators erhöht werden kann. Ein Hubmagnet kann als elektromagnetischer Aktuator genannt werden, welcher insbesondere robust und hochfunktionell ist. Weiter kann ein piezoelektrischer Aktuator oder beispielsweise eine Schwingspule (Voice coil) genannt werden, welche insbesondere aus dem Stand der Technik bekannt und etabliert ist und daher zuverlässig betrieben werden kann.

Es hat sich weiterhin als vorteilhaft erwiesen, wenn die Bedienanordnung in Richtung der ersten Betätigungsrichtung des Bedienelements zumindest einen zweiten vorbestimmten Kraft-Schwellwert aufweist. Erfindungsgemäß ist der zweite Kraft-Schwellwert größer als der erste Kraft-Schwellwert. Beim Überschreiten des zweiten Kraft-Schwellwerts erzeugt die Steuereinrichtung ein Steuersignal an den Aktuator und durch den Aktuator wird ein zweites haptisches Signal zum haptischen Wahrnehmen durch die Bedienperson an dem Bedienelement erzeugt. Somit kann ein zweiter Bedienschritt innerhalb einer Bedienanordnung bereitgestellt werden. Dies hat den Vorteil, dass entweder mehrere elektrische Geräte bedienbar sind beziehungsweise dass von einem elektrischen Gerät mehrere Zustände/Funktionen bedienbar sind. Es ist ebenfalls möglich, dass in Richtung der ersten Betätigungsrichtung noch weitere Kraft-Schwellwerte bestimmt sind, wodurch die Funktion des Bedienelements noch weiter erweitert werden kann. Die Bedienanordnung ist also von mechanischen Bauteilen innerhalb der Bedienanordnung unabhängig und es kann eine Vielzahl an Kraft-Schwellwerten innerhalb der Bedienanordnung zur Verfügung gestellt werden. Dadurch kann eine Vielzahl an elektrischen Geräten bzw. Funktionen des elektrischen Geräts bedient werden.

Erfindungsgemäß weist die Bedienanordnung in Richtung der ersten Betätigungsrichtung einen dritten vorbestimmten Kraft-Schwellwert auf. Der dritte Kraft-Schwellwert ist dabei niedriger als der erste Kraft-Schwellwert. Der dritte Kraft-Schwellwert ist durch ein Betätigen des Bedienelements ausgehend von der Position des Bedienelements beim Erreichen des ersten Kraft-Schwellwerts in einer zur ersten Betätigungsrichtung entgegengesetzten zweiten Betätigungsrichtung erreichbar. Erfindungsgemäß ist der dritte Kraft-Schwellwert nur bei Erreichen des ersten Kraft-Schwellwerts und einer dann erfolgenden Betätigung in einer zur ersten Betätigungsrichtung entgegengesetzten zweiten Betätigungsrichtung erreichbar. Die Steuereinrichtung erzeugt bei einem dann Unterschreiten des dritten Kraft-Schwellwerts entlang der zweiten Betätigungsrichtung ein Steuersignal an den Aktuator und durch den Aktuator wird ein drittes haptisches Signal zum haptischen Wahrnehmen durch die Bedienperson erzeugt. Bei dieser Ausgestaltungsform kann somit ein Kraftbereich innerhalb des ersten Kraft-Schwellwerts und des dritten Kraft-Schwellwerts erzeugt werden. Befindet sich die erfasste Kraft innerhalb dieses Bereichs, so kann nach Überschreiten des ersten Kraft-Schwellwerts das elektrische Gerät innerhalb dieses Bereichs bedient werden. Bei einem Unterschreiten des dritten Kraft-Schwellwerts kann dann das haptische Signal der Bedienperson anzeigen, dass das elektrische Gerät nun nicht mehr bedient wird. Dies hat den Vorteil, dass der Bedienperson sowohl bei einem Beginn des Bedienvorgangs des elektrischen Geräts ein haptisches Signal zur Verfügung gestellt wird und auch bei Beendigung der Betätigung der Bedienperson ein haptisches Signal zur Verfügung gestellt wird, sodass besonders sicher das Bedienen des zumindest einen elektrischen Geräts an die Bedienperson angezeigt und erkannt bzw. wahrgenommen werden kann. Insbesondere bei sicherheitsrelevanten elektrischen Geräten kann somit auf besonders zuverlässige Art und Weise der Bedienvorgang für die Person wahrnehmbar sein, ohne dass er visuell beobachtet werden muss.

In einer erfindungsgemäßen optionalen Ausgestaltung kann die Bedieneinrichtung in Richtung der Betätigungseinrichtung einen vierten vorbestimmten Kraft-Schwellwert aufweisen. Der vierte Kraft-Schwellwert kann dabei erfindungsgemäß niedriger als der zweite Kraft-Schwellwert und insbesondere größer als der erste Kraftschwellwert sein. Der vierte Kraft-Schwellwert kann durch ein Betätigen des Bedienelements ausgehend von der Position des Bedienelements beim Erreichen, insbesondere nur beim Erreichen, des zweiten Kraft-Schwellwerts und einer dann erfolgten Betätigung in einer zur ersten Betätigungsrichtung entgegengesetzten zweiten Betätigungsrichtung erreichbar sein. Insbesondere erzeugt dann bei einem Unterschreiten des vierten Kraft-Schwellwerts die Steuereinrichtung ein Steuersignal an den Aktuator, wobei durch den Aktuator ein viertes haptisches Signal zum haptischen Wahrnehmen durch die Bedienperson erzeugt wird. Insbesondere kann somit auch für eine zweite Bedienstufe der Bedienanordnung ein Kraftbereich bereitgestellt werden, innerhalb welchem das zumindest eine elektrische Gerät bedienbar ist. Dies hat den Vorteil, dass der Bedienperson sowohl bei einem Beginn des Bedienvorgangs des weiteren elektrischen Geräts bzw. der weiteren Funktion des elektrischen Geräts ein haptisches Signal zur Verfügung gestellt wird und auch bei Beendigung der Betätigung der Bedienperson ein haptisches Signal zur Verfügung gestellt wird, sodass besonders sicher das Bedienen des zumindest einen elektrischen Geräts an die Bedienperson angezeigt werden kann. Insbesondere bei sicherheitsrelevanten elektrischen Geräten kann somit auf besonders zuverlässige Art und Weise der Bedienvorgang für die Person wahrnehmbar werden, ohne dass er visuell beobachtet werden muss.

Die Betätigung in eine erste Betätigungsrichtung sind ausgehend von einer Grundstellung des Bedienelements betrachtet. Die dann auch nach dem Betätigen in die erste Betätigungsrichtung erfolgenden Betätigungen in eine zweite Betätigungsrichtung erfolgen dann in Richtung der Grundstellung hin, wobei diese weiteren Kraft-Schwellwerte dann jedoch vor dem Erreichen der Grundstellung erreicht werden.

Es hat sich weiterhin als vorteilhaft erwiesen, wenn das Bedienelement ausgehend von einer Grundstellung in eine zweite Betätigungsrichtung, welche zur ersten Betätigungsrichtung unterschiedlich ist, insbesondere entgegengesetzt ist, betätigbar ist. Insbesondere kann mittels dieser Ausgestaltungsform eine weitere Möglichkeit gegeben werden, einen weiteren Zustand des einen elektrischen Geräts zu bedienen beziehungsweise ein weiteres elektrisches Gerät zu bedienen. Somit kann für weitere elektrische Geräte beziehungsweise für mehrere Zustände des einen elektrischen Geräts eine Bedienanordnung zur Verfügung gestellt werden, wodurch der Montageaufwand verringert werden kann sowie Bauteile innerhalb des Kraftfahrzeugs eingespart werden können.

Es hat sich weiterhin als vorteilhaft erwiesen, wenn die Bedienanordnung in Richtung der zweiten Betätigungsrichtung aus der Grundstellung der Bedienanordnung heraus gesehen einen weiteren vorbestimmten Kraft-Schwellwert aufweist, wobei bei dem Überschreiten des weiteren Kraft-Schwellwerts die Steuereinrichtung der Bedienanordnung ein Steuersignal an den Aktuator erzeugt und durch den Aktuator ein weiteres haptisches Signal zum haptischen Wahrnehmen durch die Bedienperson an dem Bedienelement erzeugt ist. Insbesondere kann somit auch in der zweiten Betätigungsrichtung der Bedienperson haptisch angezeigt (durch das haptische Wahrnehmen) werden, dass das elektrische Gerät bedient wird.

Gemäß einer weiteren vorteilhaften Ausgestaltungsform kann die Bedienanordnung in Richtung der zweiten Betätigungsrichtung einen nochmals weiteren vorbestimmten Kraft-Schwellwert aufweisen. Der nochmals weitere Kraft-Schwellwert kann dabei insbesondere niedriger als der weitere Kraft-Schwellwert sein, wobei der nochmals weitere Kraft-Schwellwert durch ein Betätigen des Bedienelements ausgehend von der Position des Bedienelements beim Erreichen, und insbesondere nur beim Erreichen, des weiteren Kraft-Schwellwerts in dann wiederum die erste Betätigungsrichtung erreichbar sein. Insbesondere bei einem dann Unterschreiten des nochmals weiteren Kraft-Schwellwerts vor dem Erreichen der Grundstellung des Bedienelements kann die Steuereinrichtung ein Steuersignal an den Aktuator erzeugen. Durch den Aktuator ist dann ein nochmals weiteres haptisches Signal zum haptischen Wahrnehmen durch die Bedienperson erzeugt. Dies hat den Vorteil, dass der Bedienperson sowohl bei einem Beginn des Bedienvorgangs in die zweite Betätigungsrichtung des elektrischen Geräts ein haptisches Signal zur Verfügung gestellt wird und auch bei Beendigung der Betätigung der Bedienperson ein haptisches Signal zur Verfügung gestellt wird, sodass besonders sicher das Bedienen des zumindest einen elektrischen Geräts an die Bedienperson angezeigt werden kann. Insbesondere bei sicherheitsrelevanten elektrischen Geräten kann somit auf besonders zuverlässige Art und Weise der Bedienvorgang für die Person wahrnehmbar sein.

Besonders vorteilhaft ist das Konzept dadurch, dass eine Mehrzahl von einfachen und intuitiven Bewegungen eine Vielzahl von Einstellungen eines oder mehrerer elektrischer Geräte ermöglicht und dies durch individuelle haptische Signale zuverlässig wahrgenommen und verstanden werden kann.

Insbesondere kann auch hier vorgesehen sein, dass in Richtung der zweiten Betätigungsrichtung eine Mehrzahl an Kraft-Schwellwerten zur Verfügung gestellt wird, sodass mittels einer Bedienanordnung eine Vielzahl an Zuständen des elektrischen Geräts beziehungsweise eine Vielzahl an elektrischen Geräten bedienbar ist. Somit kann mit der einen Bedienanordnung eine Vielzahl elektrischer Geräte bedient werden. Dies wiederum führt zu einer Bauteileinsparung und zur Verminderung von Montagezeit während beispielsweise einer Kraftfahrzeugherstellung.

Es hat sich weiterhin als vorteilhaft erwiesen, wenn die Bedienanordnung zumindest ein Entkopplungselement aufweist, mittels welchem eine Bewegung des Bedienelements von einer Basis der Bedienanordnung entkoppelbar ist. Dies hat den Vorteil, dass beispielsweise durch eine Vibrationsbewegung des Aktuators diese Bewegung nicht an die Basis der Bedienanordnung weitergegeben werden kann. Dadurch kann beispielsweise bei einer Anordnung der Steuereinrichtung auf der Basis eine mechanische Einwirkung auf die Steuereinrichtung vermindert werden. Dies führt zur Verlängerung der Lebensdauer der Bedienanordnung. Insbesondere können dabei die Entkopplungselemente beziehungsweise das Entkopplungselement dämpfend wirken.

In einer weiteren vorteilhaften Ausgestaltungsform kann das Bedienelement entlang einer Längsachse der Bedienanordnung bewegbar, insbesondere bedienbar, sein. Insbesondere kann dabei das Bedienelement beispielsweise als Schiebeschalter beziehungsweise als ein Wippschalter ausgebildet sein. Bei diesen beiden Schalterarten handelt es sich insbesondere im Kraftfahrzeugbau um bereits etablierte Schaltertypen, welche bereits auch von den Bedienpersonen, insbesondere von den Fahrern, intuitiv bedienbar sind. Als Beispiel kann hierzu ein elektrischer Fensterheber in einem Kraftfahrzeug genannt werden. Dadurch kann eine intuitive Bedienung bereitgestellt werden, sodass die Bedienperson bereits von Anfang an sehr sicher das Bedienelement bedienen kann.

In einer weiteren vorteilhaften Ausgestaltungsform kann das Bedienelement um eine Drehachse der Schalteranordnung drehbar, insbesondere bedienbar, sein. Bei dieser Ausgestaltungsform kann das Bedienelement beispielsweise ein Drehknopf sein. Bei einem Drehknopf handelt es sich um ein bereits im Kraftfahrzeugbau bekanntes Bedienelement. Dadurch kann ebenfalls eine intuitive Bedienung bereitgestellt werden, sodass die Bedienperson bereits von Anfang an sehr sicher das Bedienelement bedienen kann.

Ein erfindungsgemäßes Fahrerassistenzsystem umfasst eine erfindungsgemäße Bedienanordnung.

Es hat sich insbesondere als vorteilhaft erwiesen, wenn auf einer Anzeigevorrichtung des Fahrerassistenzsystems das zu bedienende elektrische Gerät und/oder eine erfasste Kraft und/oder der Kraft-Schwellwert anzeigbar ist. Insbesondere kann somit der Bedienperson optisch und haptisch angezeigt werden, dass eine Bedienung des elektrischen Geräts stattfindet und beispielsweise in welchem Zustand sich das elektrische Gerät gerade befindet. Insbesondere kann dies beispielsweise durch eine Kraftanzeige realisiert werden, wobei die einzelnen Kraft-Schwellwerte insbesondere ebenfalls mit angezeigt werden.

Die Erfindung betrifft ebenfalls ein Kraftfahrzeug mit einem Fahrerassistenzsystem.

Die Erfindung betrifft ebenfalls ein Verfahren zum Bedienen einer Bedienanordnung von zumindest einem elektrischen Gerät in einem Kraftfahrzeug. Auf ein Bedienelement der Bedienanordnung wird bei dessen Betätigung in eine erste Betätigungsrichtung eine Kraft durch eine Bedienperson ausgeübt. Die ausgeübte Kraft wird mittels eines Kraftsensors erfasst. Bei einem Überschreiten eines vorbestimmten ersten Kraft-Schwellwerts wird ein Schaltsignal der Bedienanordnung zum Bedienen des elektrischen Geräts erzeugt.

Ein wesentlicher Gedanke der Erfindung ist darin zu sehen, dass bei dem Überschreiten des ersten Kraft-Schwellwerts von einer Steuereinrichtung der Bedienanordnung ein Steuersignal an einen Aktuator der Bedienanordnung erzeugt wird. Es wird dann ein haptisches Signal zum haptischen Wahrnehmen durch die Bedienperson am Bedienelement durch den Aktuator erzeugt.

Die mit Bezug auf die erfindungsgemäße Bedienanordnung vorgestellten bevorzugten Ausführungsformen und deren Vorteile gelten entsprechend für das erfindungsgemäße Fahrerassistenzsystem, das erfindungsgemäße Kraftfahrzeug sowie das erfindungsgemäße Verfahren.

Die Erfindung wird nun anhand von bevorzugten Ausführungsbeispielen sowie unter Bezugnahme auf die beigefügten Zeichnungen erläutert.

Dabei zeigen:
- Fig. 1: ein Kraftfahrzeug gemäß einer Ausführungsform der vorliegenden Erfindung, welches eine Bedienanordnung aufweist;
- Fig. 2: eine schematische Schnittansicht eines weiteren Ausführungsbeispiels einer erfindungsgemäßen Bedienanordnung;
- Fig. 3: eine schematische Schnittansicht eines Ausführungsbeispiels einer erfindungsgemäßen Bedienanordnung; und
- Fig. 4: ein Weg-Kraft-Diagramm für eine Ausführungsform der erfindungsgemäßen Bedienanordnung.

In den Figuren werden gleiche und funktionsgleiche Elemente mit den gleichen Bezugszeichen versehen.

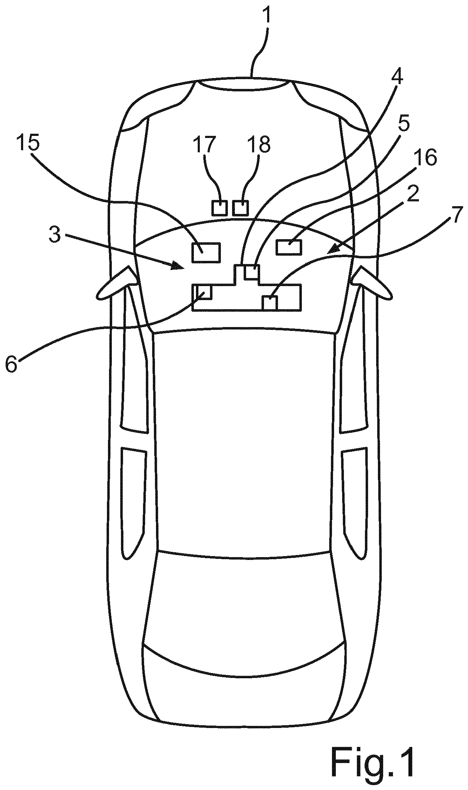

Fig. 1 zeigt ein Kraftfahrzeug 1 gemäß einer Ausführungsform der vorliegenden Erfindung in einer Draufsicht. Das Kraftfahrzeug 1 ist vorliegend als Personenkraftwagen ausgebildet. Das Kraftfahrzeug 1 umfasst einen Innenraum 2, in welchem eine Bedienanordnung 3 angeordnet ist. Die Bedienanordnung 3, welche vorliegend schematisch dargestellt ist, umfasst ein Bedienelement 4, welches von einem Insassen des Kraftfahrzeugs 1 bedient werden kann. Insbesondere kann die Bedienanordnung 3 in dem Innenraum 2 des Kraftfahrzeugs 1 verbaut angeordnet sein, oder auf einem mobilen Endgerät ausgebildet sein. Mit der Bedienanordnung 3 kann mittels eines Schaltsignals der Bedienanordnung 3 zumindest ein elektrisches Gerät 17, 18 des Kraftfahrzeugs 1 und/oder zumindest eine Betriebsfunktion des zumindest einen elektrischen Geräts 17, 18 ausgewählt und/oder eingestellt werden.

Mit der Bedienanordnung 3 kann eine Bedienhandlung in Form der Betätigung des Bedienelements 4 erfasst werden. Insbesondere kann dazu die Bedienanordnung 3 eine Erfassungseinrichtung 5 aufweisen, welche beispielsweise einen berührungsempfindlichen Sensor umfassen kann. Mit dieser Erfassungseinrichtung 5 kann beispielsweise eine Berührung des Bedienelements 4 mit zumindest einem Finger oder einem entsprechenden Eingabegerät erfasst werden. Somit kann eine ungewollte Bedienung der Bedienanordnung 3 verhindert werden, da beispielsweise eine Bedienung des elektrischen Geräts 17, 18 nur erfolgt, wenn auch die Erfassungseinrichtung 5 beispielsweise einen Finger des Bedieners erfasst hat. Ferner kann beispielsweise mit der Erfassungseinrichtung 5 die genaue Position der Berührung auf dem Bedienelement 4 erkannt werden, sodass für eine Mehrzahl von örtlich unterschiedlichen Berührstellen auf dem Bedienelement 4 eine einzige Erfassungseinrichtung 5 ausreichend sein kann.

Ebenfalls möglich ist, dass die Bedienanordnung 3 eine Mehrzahl an berührungsempfindlichen Sensoren aufweist, wobei bei einem Berühren eines jeweiligen berührungsempfindlichen Sensors eine jeweilige unterschiedliche Funktion des elektrischen Geräts 17,18 und/oder ein jeweiliges unterschiedliches elektrische Gerät 17, 18 bedienbar ist. Mit anderen Worten können über die jeweiligen berührungsempfindlichen Sensoren unterschiedliche Funktionen des elektrischen Geräts 17, 18 und/oder unterschiedliche elektrischen Geräte 17, 18 bedient werden.

Ferner umfasst die Bedienanordnung 3 einen Aktuator 6, mittels welchem das Bedienelement 4 zum Ausgeben einer haptischen Rückmeldung an die Bedienperson bewegt werden kann. Insbesondere kann der Aktuator 6 bei einem Überschreiten eines ersten Kraft-Schwellwerts A1 einer Steuereinrichtung 7 der Bedienanordnung 3 ein Steuersignal an den Aktuator 6 erzeugen und durch den Aktuator 6 wird ein haptisches Signal zum haptischen Wahrnehmen durch eine nicht dargestellte Bedienperson an dem Bedienelement 4 erzeugt.

Im Innenraum 2 des Kraftfahrzeugs 1 kann weiterhin eine Anzeigevorrichtung 15 angeordnet sein, bei welcher beispielsweise ein Bedienen des elektrischen Geräts 17, 18 beziehungsweise eine erfasste Kraft durch die Bedienanordnung 3 beziehungsweise ein definierter Kraftschwellwert A1, A2, A3, A4, B1, B2 mit denen Bedienszenarien eines oder mehrerer elektrischer Geräte 17, 18 verknüpft sind, angezeigt werden kann. Die Anzeigevorrichtung 15 kann als Teil eines Fahrerassistenzsystems 16 ausgebildet sein.

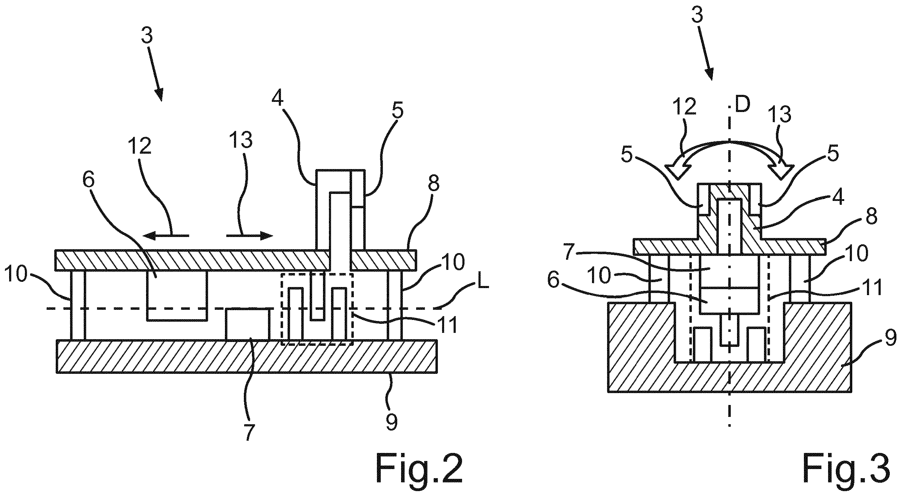

Fig. 2 zeigt die Bedienanordnung 3 gemäß einer ersten Ausführungsform in einer geschnittenen Seitenansicht. Das Bedienelement 4 mit der Erfassungseinrichtung 5 ist insbesondere auf einer Bedienoberfläche 8 angeordnet. Insbesondere ist das Bedienelement 4 derart ausgebildet, dass eine nicht dargestellte Bedienperson, insbesondere mit seinem Finger, das Bedienelement 4 bedienen kann. Die Bedienoberfläche 8 ist gegenüber einer Basis 9 der Bedienanordnung 3 insbesondere beweglich angeordnet. Insbesondere kann dies gewährleistet werden, indem die Bedienoberfläche 8 über zumindest ein Entkopplungselement 10, in diesem Ausführungsbeispiel insbesondere zwei Entkopplungselemente 10, mit der Basis 9 verbunden ist. Die Entkopplungselemente 10 dienen dabei insbesondere dazu, sowohl die Bedienoberfläche 8 beweglich zu halten als auch Vibrationen des Aktuators 6 gegenüber der Basis 9 zu dämpfen. Insbesondere kann so verhindert werden, dass mechanische Kräfte an insbesondere die Steuereinrichtung 7 übertragen werden.

Die Bedienanordnung 3 weist weiterhin einen Kraftsensor 11 auf, welcher dazu ausgebildet ist, eine auf das Bedienelement 4 ausgeübte Kraft zu erfassen. Insbesondere kann das Bedienelement 4 derart ausgebildet sein, dass dieses in zumindest zwei Betätigungsrichtungen 12, 13, bedienbar ist, wobei 12 eine erste Betätigungsrichtung darstellt und 13 eine zweite Betätigungsrichtung darstellt, erfassen kann. In Fig. 2 sind die Betätigungsrichtungen 12, 13 entlang einer Längsachse L der Bedienanordnung 3 zu sehen. Der Aktuator 6 ist insbesondere an der Bedienoberfläche 8 angeordnet, sodass bei der Ausgabe eines haptischen Signals durch den Aktuator 6 insbesondere die Bedienoberfläche 8 und dabei insbesondere das Bedienelement 4 eine haptisch wahrnehmbare Bewegung erfährt, sodass die Bedienperson das haptische Signal des Aktuators 6 wahrnehmen kann. Bei dem Aktuator 6 kann es sich insbesondere um einen Vibrationsmotor handeln. Es kann sich bei dem Aktuator 6 auch um einen Linearmotor handeln. Ebenfalls möglich ist, dass es sich bei dem Aktuator 6 um einen elektromagnetischen Aktuator, beispielsweise einem Hubmagneten, oder einem piezoelektrischen Aktuator, oder beispielsweise einer Schwingspule (Voice coil), handeln kann.

Bei den in Fig. 2 ausgeführten Ausführungsformen kann es sich bei dem Bedienelement 4 beispielsweise um einen Wippschalter oder einen Druckschalter handeln.

Die Steuereinrichtung 7 kann insbesondere von der erfassten Kraft durch den Kraftsensor 11 ein zugeordnetes Steuersignal erzeugen, welches den Aktuator 6 steuert, welcher wiederum ein individuelles haptisches Signal erzeugt. Insbesondere kann vorgesehen sein, dass die Steuereinrichtung 7 dazu ausgebildet ist, die mehreren vorbestimmten Kraft-Schwellwerte A1, A2, A3, A4, B1, B2 zu erfassen und jeweils spezifische, zugeordnete haptische Signale und Schaltsignale für das zumindest eine elektrische Gerät 17, 18 zu generieren.

Fig. 3 zeigt eine weitere Bedienanordnung 3 gemäß einer weiteren Ausführungsform in einer geschnittenen Seitenansicht. Bei der in Fig. 3 dargestellten Ausführungsform kann es sich insbesondere um einen Drehknopf handeln, welcher insbesondere um eine Drehachse D drehbar ist. Das Bedienelement 4 mit der Bedienoberfläche 8 kann insbesondere um die Drehachse D drehbar angeordnet sein. Mit anderen Worten kann bei einer Betätigung des Bedienelements 4 das Bedienelement 4 mit der Bedienoberfläche 8 in Rotation um die Drehachse D versetzt werden. Insbesondere die Erfassungseinrichtung 5 kann dabei feststellen, ob beispielsweise ein Finger einer Bedienperson anliegt. Der Kraftsensor 11 kann beispielsweise bei dieser Ausführungsform kapazitiv ausgebildet sein, sodass bei einer Änderung der Kapazität gleichzeitig die Kraft mit erfasst werden kann. Ebenfalls möglich ist, dass bei dieser Ausgestaltungsform der Kraftsensor 11 entsprechend einem Potentiometer aufgebaut ist.

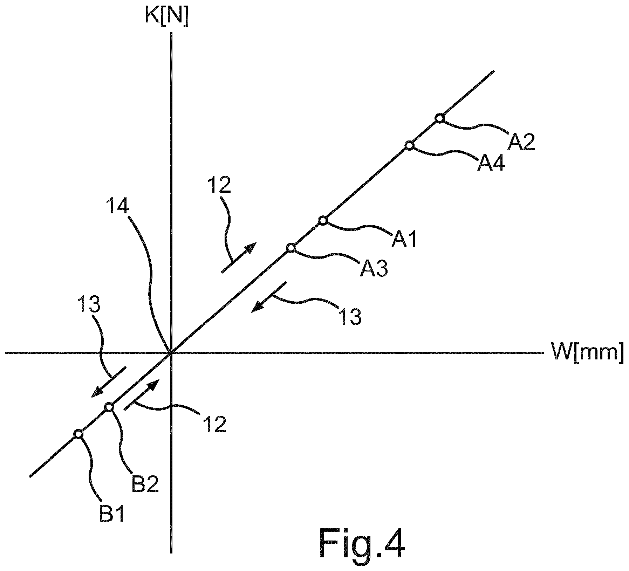

Fig. 4 zeigt schematisch ein Weg-Kraft-Diagramm (W-K-Diagramm) für ein Beispiel der Bedienanordnung 3. Bei einem Betätigen des Bedienelements 4 ausgehend von dessen Grundstellung 14 kann insbesondere eine Kraft auf das Bedienelement 4 in eine erste Betätigungsrichtung 12 ausgeübt werden. Beim Erreichen des ersten Kraftschwellwerts A1 entlang dieser ersten Betätigungsrichtung 12 kann insbesondere das Schaltsignal erzeugt und das elektrisches Gerät 17, 18 damit bedient oder eine Betriebsfunktion des elektrischen Geräts 17, 18 ausgewählt werden. Es kann weiterhin vorgesehen sein, dass insbesondere bei einem Erhöhen der Kraft auf das Bedienelement 4 in Richtung der ersten Betätigungsrichtung 12 dann ein zweiter vorbestimmter Kraft-Schwellwert A2 erreicht werden kann. Beim Überschreiten des insbesondere zweiten Kraft-Schwellwerts A2 kann beispielsweise auch ein weiterer Zustand/Funktion des elektrischen Geräts 17, 18 bedient werden oder es kann auch ein weiteres elektrisches Gerät 17, 18 bedient oder ausgewählt werden.

Insbesondere kann weiter vorgesehen sein, dass die Bedienanordnung 3 einen vorbestimmten dritten Kraft-Schwellwert A3 aufweist. Dieser ist kleiner als der erste und der zweite Kraft-Schwellwert A1, A2. Der dritte Kraft-Schwellwert A3 kann insbesondere nur dann erreicht werden, wenn ausgehend von einer Grundstellung 14 in Richtung der ersten Betätigungsrichtung 12 bereits der erste Kraft-Schwellwert A1 erreicht wurde. Insbesondere bei einem Nachlassen der Kraft nach dem Erreichen des ersten Kraft-Schwellwerts A1 und bei einem damit erfolgten Betätigen des Bedienelements 4 in eine zur ersten Betätigungsrichtung 12 entgegengesetzte zweite Betätigungsrichtung 13 und somit ausgehend vom ersten Kraft-Schwellwert A1 in Richtung der Grundstellung 14 wird bei einem Unterschreiten des dritten Kraft-Schwellwerts A3 ein Schaltsignal zum Steuern des zumindest einen elektrischen Geräts 17, 18, bzw. einer Funktion des elektrischen Geräts 17, 18 erzeugt. Mit anderen Worten kann aus der Grundstellung 14, was bedeutet, dass keine Kraft auf das Bedienelement 4 ausgeübt wird, in der ersten Betätigungsrichtung 12 der erste Kraft-Schwellwert A1 überschritten werden. Bei einem Unterschreiten des dritten Kraft-Schwellwerts A3 wird die Steuereinrichtung 7 angesteuert, und der Aktuator 6 erzeugt ein drittes haptisches Signal. Es können bevorzugt das erste haptische Signal und das dritte haptische Signal unterschiedlich sein. Beispielsweise können unterschiedliche Vibrationsstärken und/oder unterschiedliche Vibrationsfrequenzen erzeugt.

Es kann weiterhin vorgesehen sein, dass in der ersten Betätigungsrichtung 12 nach dem ersten Kraft-Schwellwert A1 der zweite Kraft-Schwellwert A2 liegt. Somit kann beispielsweise realisiert werden, dass mittels einer Bedienanordnung 3 beispielsweise ein zweiter Zustand des elektrischen Geräts 17, 18 bedient werden kann beziehungsweise ein weiteres elektrisches Gerät 17, 18 bedient werden kann. Der zweite Kraft-Schwellwert A2 ist insbesondere größer als der erste Kraft-Schwellwert A1. Es kann weiterhin vorgesehen sein, dass ausgehend von dem zweiten Kraft-Schwellwert A2 in der zweiten Betätigungsrichtung 13 ein vierter Kraft-Schwellwert A4 liegt. Insbesondere kann der vierte Kraft-Schwellwert A4 niedriger sein als der zweite Kraft-Schwellwert A2, jedoch höher sein als der erste Kraft-Schwellwert A1. Der vierte Kraft-Schwellwert A4 kann insbesondere nur dann erreicht werden, wenn ausgehend von der Grundstellung 14 in Richtung der ersten Betätigungsrichtung 12 bereits der zweite Kraft-Schwellwert A2 erreicht wurde. Insbesondere bei einem Nachlassen der Kraft nach dem Erreichen des zweiten Kraft-Schwellwerts A2 und bei einem damit erfolgtem Betätigen des Bedienelements 4 in die zur ersten Betätigungsrichtung 12 entgegengesetzte zweite Betätigungsrichtung 13 und somit ausgehend vom zweiten Kraft-Schwellwert A2 in Richtung der Grundstellung 14 wird bei einem Unterschreiten des vierten Kraft-Schwellwerts A4 ein Schaltsignal zum Steuern des zumindest einen elektrischen Geräts 17, 18, bzw. einer Funktion des elektrischen Geräts 17, 18 erzeugt.

Mit anderen Worten kann aus der Grundstellung 14, was bedeutet, dass keine Kraft auf das Bedienelement 4 ausgeübt wird, in der ersten Betätigungsrichtung 12 der zweite Kraft-Schwellwert A2 überschritten werden. Somit kann ein viertes haptisches Signal ausgegeben werden, welches beispielsweise ein nicht mehr Bedienen des elektrischen Geräts 17, 18 anzeigt. Sollte in erster Betätigungsrichtung 12 die Bedienperson den zweiten Kraft-Schwellwert A2 erreicht haben und nun mit einer geringeren Kraftbeaufschlagung in Richtung der zweiten Betätigungsrichtung 13 drücken, wird bei einem Unterschreiten des vierten Kraft-Schwellwerts A4 ein viertes haptisches Signal erzeugt.

Mittels dieser Ausführungsform kann der Bedienperson besonders einfach haptisch angezeigt werden, wann sie eine Bedienung eines elektrischen Geräts 17, 18 angefangen hat und wann die Bedienung beendet ist. Insbesondere kann weiterhin vorgesehen sein, dass noch weitere Kraft-Schwellwerte in der ersten Betätigungsrichtung 12 ausgebildet sind. Dies ist möglich, da es sich bei dem Aktuator 6 um einen elektrisch gesteuerten Aktuator 6 handelt und nicht um einen mechanischen Aktuator 6. Der mechanische Aktuator 6 wäre aufgrund seiner mechanischen Ausführungsform in der Anzahl der Kraft-Schwellwerte A1, A2, A3, A4, B1, B2 begrenzt, während der Aktuator 6 lediglich ein Steuersignal der Steuereinrichtung 7 zum Erzeugen des haptischen Signals benötigt.

Ausgehend von der Grundstellung 14 kann die Bedieneinrichtung 3 auch in der zweiten Betätigungsrichtung 13 betätigt werden und entlang dieses Weges einen weiteren Kraft-Schwellwert B1 aufweisen. Insbesondere kann beim Überschreiten des weiteren Kraft-Schwellwerts B1 das elektrisches Gerät 17, 18, bzw. eine Funktion des elektrischen Geräts 17, 18 bedient werden. Insbesondere kann auch beim Überschreiten des Kraft-Schwellwerts B1 die Steuereinrichtung 7 entsprechend angesteuert werden, welches wiederum ein Steuersignal an den Aktuator 6 erzeugt, wobei der Aktuator 6 ein haptisches Signal zum Wahrnehmen durch die Bedienperson erzeugt. Bei einer Verminderung der Kraft in die zweite Betätigungsrichtung 13, kann insbesondere nur nach einem Erreichen des weiteren Kraft-Schwellwerts B1 die Bedienanordnung 3 einen nochmals weiteren Kraft-Schwellwert B2 aufweisen. Dieser ist kleiner als der weitere Kraft-Schwellwert B1. Der nochmals weitere Kraft-Schwellwert B2 kann insbesondere nur dann erreicht werden, wenn ausgehend von einer Grundstellung 14 in Richtung der zweiten Betätigungsrichtung 13 bereits der weitere Kraft-Schwellwert B1 erreicht wurde.

Insbesondere bei einem Nachlassen der Kraft nach dem Erreichen des ersten Kraft-Schwellwerts B1 und bei einem damit erfolgtem Betätigen des Bedienelements 4 in die zur zweiten Betätigungsrichtung 13 entgegengesetzte erste Betätigungsrichtung 12 und somit ausgehend vom weiteren Kraft-Schwellwert B1 in Richtung der Grundstellung 14 wird bei einem Unterschreiten des nochmals weiteren Kraft-Schwellwerts B2 ein Schaltsignal zum Steuern des zumindest einen elektrischen Geräts17, 18, bzw. einer Funktion des elektrischen Geräts 17, 18 erzeugt. Mit anderen Worten kann aus der Grundstellung 14, was bedeutet, dass keine Kraft auf das Bedienelement 4 ausgeübt wird, in der zweiten Betätigungsrichtung 13 der weitere Kraft-Schwellwert B1 überschritten werden. Insbesondere kann bei einem Unterschreiten des nochmals weiteren Kraft-Schwellwerts B2 (in Richtung der ersten Betätigungsrichtung 12 ausgehend vom weiteren Kraft-Schwellwert B1 und in Richtung zur Grundstellung 14) der Aktuator 6 ein nochmals weiteres haptisches Signal erzeugen.

Insbesondere kann vorgesehen sein, dass bei einem Überschreiten des weiteren Kraft-Schwellwerts B1 das elektrische Gerät 17, 18 aktiviert wird und bei einem Unterschreiten des nochmals weiteren Kraft-Schwellwerts B2 das elektrische Gerät 17, 18 deaktiviert wird.

Insbesondere kann vorgesehen sein, dass die erzeugten haptischen Signale für die unterschiedlichen Kraft-Schwellwerte A1, A2, A3, A4, B1, B2 auch für die Wahrnehmung durch die Bedienperson unterschiedlich sind. Beispielsweise können sich die haptischen Signale in ihrer Vibrationsintensität und/oder in ihrer Vibrationsfrequenz unterscheiden.

Insgesamt können somit mehrere Kraft-Bereiche bereitgestellt werden, innerhalb welcher das elektrische Gerät 17, 18 beziehungsweise die elektrischen Geräte 17, 18 bedient werden können und die Bedienperson eine jeweilige haptisches Rückmeldung erhält, ob eine Bedienung des elektrischen Geräts 17, 18 durchgeführt wird.

Des Weiteren hat die Bedienanordnung 3 den Vorteil, dass beispielsweise bei einer Nichtbedienung des elektrischen Geräts 17, 18 aufgrund eines Defekts des elektrischen Geräts 17, 18 die Steuereinrichtung 7 kein haptisches Signal erzeugt. Insbesondere bei sicherheitsrelevanten elektrischen Geräten 17, 18 hat dies den Vorteil, dass die Bedienperson jederzeit informiert ist, ob eine Bedienung des elektrischen Geräts 17, 18 stattgefunden hat.

## Patentansprüche

1. Bedienanordnung (3) zum Bedienen von zumindest einem elektrischen Gerät (17, 18) in einem Kraftfahrzeug (1), mit einem Bedienelement (4), auf welches beim Betätigen des Bedienelements (4) ausgehend von einer Grundstellung (14) des Bedienelements (4) betrachtet in eine erste Betätigungsrichtung (12) eine Kraft durch eine Bedienperson ausübbar ist, und mit einem Kraftsensor (11), mittels welchem die ausübbare Kraft erfassbar ist, wobei bei einem Überschreiten eines vorbestimmten ersten Kraft-Schwellwerts (A1), die Bedienanordnung (3) ein Schaltsignal zum Bedienen des elektrischen Geräts (17, 18) erzeugt,
wobei die Bedienanordnung (3) einen Aktuator (6) aufweist, wobei bei dem Überschreiten des ersten Kraft-Schwellwerts (A1) eine Steuereinrichtung (7) der Bedienanordnung (3) ein Steuersignal an den Aktuator (6) erzeugt und durch den Aktuator (6) ein erstes haptisches Signal zum haptischen Wahrnehmen durch die Bedienperson an dem Bedienelement (4) erzeugt ist, wobei das Bedienelement (4) ein Wippschalter ist,
**dadurch gekennzeichnet, dass**
die Bedienanordnung (3) in Richtung der ersten Betätigungsrichtung (12) des Bedienelements (4) zumindest einen zweiten vorbestimmten Kraft-Schwellwert (A2) aufweist, welcher größer ist, als der erste Kraft-Schwellwert (A1), und beim Überschreiten des zweiten Kraft-Schwellwerts (A2) die Steuereinrichtung (7) ein Steuersignal an den Aktuator (6) erzeugt und durch den Aktuator (6) ein zweites haptisches Signal zum haptischen Wahrnehmen durch die Bedienperson an dem Bedienelement (4) erzeugt ist, und
die Bedienanordnung (3) in Richtung der ersten Betätigungsrichtung (12) einen dritten vorbestimmten Kraft-Schwellwert (A3) aufweist, wobei der dritte Kraft-Schwellwert (A3) niedriger als der erste Kraft-Schwellwert (A1) ist, wobei der dritte Kraft-Schwellwert (A3) durch ein Betätigen des Bedienelements (4) ausgehend von der Position des Bedienelements (4) beim Erreichen des ersten Kraft-Schwellwerts (A1) in eine zur ersten Betätigungsrichtung (12) entgegengesetzte zweite Betätigungsrichtung (13) erreichbar ist, und bei einem dann Unterschreiten des dritten Kraft-Schwellwerts (A3) die Steuereinrichtung (7) ein Steuersignal an den Aktuator (6) erzeugt und durch den Aktuator (6) ein drittes haptisches Signal zum haptischen Wahrnehmen durch die Bedienperson an dem Bedienelement (4) erzeugt ist, und/oder
die Bedienanordnung (3) in Richtung der ersten Betätigungsrichtung (12) einen vierten vorbestimmten Kraft-Schwellwert (A4) aufweist, wobei der vierte Kraft-Schwellwert (A4) niedriger als der zweite Kraft-Schwellwert (A2) ist, wobei der vierte Kraft-Schwellwert (A4) durch ein Betätigen des Bedienelements (4) ausgehend von der Position des Bedienelements (4) beim Erreichen des zweiten Kraft-Schwellwerts (A2) in eine zur ersten Betätigungsrichtung (12) entgegengesetzte zweite Betätigungsrichtung (13) erreichbar ist, und bei einem dann Unterschreiten des vierten Kraft-Schwellwerts (A4) die Steuereinrichtung (7) ein Steuersignal an den Aktuator (6) erzeugt und durch den Aktuator (6) ein viertes haptisches Signal zum haptischen Wahrnehmen durch die Bedienperson an dem Bedienelement (4) erzeugt ist.

2. Bedienanordnung (3) nach Anspruch 1,
**dadurch gekennzeichnet, dass**
das Bedienelement (4) zumindest einen berührungsempfindlichen Sensor (5) aufweist.

3. Bedienanordnung (3) nach einem der vorhergehenden Ansprüche,
**dadurch gekennzeichnet, dass**
die Bedienanordnung (3) als Aktuator (6) einen Vibrationsmotor und/oder einen Linearmotor und/oder einen elektromagnetischen Aktuator und/oder einen piezoelektrischen Aktuator aufweist.

4. Bedienanordnung (3) nach einem der vorhergehenden Ansprüche,
**dadurch gekennzeichnet, dass**
das Bedienelement (4) ausgehend von der Grundstellung (14) des Bedienelements (4) betrachtet in eine zweite Betätigungsrichtung (13), welche zur ersten Betätigungsrichtung (12) unterschiedlich ist, insbesondere entgegengesetzt, betätigbar ist.

5. Bedienanordnung (3) nach Anspruch 4,
**dadurch gekennzeichnet, dass**
die Bedienanordnung (3) ausgehend von der Grundstellung (14) des Bedienelements (4) betrachtet in Richtung der zweiten Betätigungsrichtung (13) einen weiteren vorbestimmten Kraft-Schwellwert (B1) aufweist, wobei bei dem Überschreiten des weiteren Kraft-Schwellwerts (B1) die Steuereinrichtung (7) der Bedienanordnung (3) ein Steuersignal an den Aktuator (6) erzeugt und durch den Aktuator (6) ein weiteres haptisches Signal zum haptischen Wahrnehmen durch die Bedienperson an dem Bedienelement (4) erzeugt ist.

6. Bedienanordnung (3) nach Anspruch 5,
**dadurch gekennzeichnet, dass**
die Bedienanordnung (3) ausgehend von der Grundstellung (14) des Bedienelements (4) betrachtet in Richtung der zweiten Betätigungsrichtung (13) einen nochmals weiteren vorbestimmten Kraft-Schwellwert (B2) aufweist, wobei der nochmals weitere Kraft-Schwellwert (B2) niedriger als der weitere Kraft-Schwellwert (B1) ist, wobei der nochmals weitere Kraft-Schwellwert (B2) durch ein Betätigen des Bedienelements (4) ausgehend von der Position des Bedienelements (4) beim Erreichen des weiteren Kraft-Schwellwerts (B1) und einem dann Betätigen des Bedienelements (4) in die erste Betätigungsrichtung (12) erreichbar ist, und bei einem dann Unterschreiten des nochmals weiteren Kraft-Schwellwerts (B2) die Steuereinrichtung (7) ein Steuersignal an den Aktuator (6) erzeugt und durch den Aktuator (6) ein nochmals weiteres haptisches Signal zum haptischen Wahrnehmen durch die Bedienperson am Bedienelement (4) erzeugt ist.

7. Bedienanordnung (3) nach einem der vorhergehenden Ansprüche,
**dadurch gekennzeichnet, dass**
die Bedienanordnung (3) zumindest ein Entkopplungselement (10) aufweist, mittels welchem eine Bewegung des Bedienelements (4) von einer Basis (9) der Bedienanordnung (3) entkoppelbar ist.

8. Bedienanordnung (3) nach einem der vorhergehenden Ansprüche,
**dadurch gekennzeichnet, dass**
das Bedienelement (4) entlang einer Längsachse (L) der Bedienanordnung (3) bewegbar ist.

9. Bedienanordnung (3) nach einem der Ansprüche 1 bis 5,
**dadurch gekennzeichnet, dass**
das Bedienelement (4) um eine Drehachse (D) der Bedienanordnung (3) drehbar ist.

10. Fahrerassistenzsystem (16) mit einer Bedienanordnung (3) nach einem der Ansprüche 1 bis 9.

11. Fahrerassistenzsystem (16) nach Anspruch 10,
**dadurch gekennzeichnet, dass**
auf einer Anzeigevorrichtung (15) des Fahrerassistenzsystems (16) das zu bedienende elektrische Gerät (17, 18) ist und/oder eine erfasste Kraft und/oder der Kraft-Schwellwert (A1, A2, A3, A4, B1, B2) anzeigbar ist.

12. Kraftfahrzeug (1) mit einem Fahrerassistenzsystem (16) nach einem der Ansprüche 13 bis 11.

13. Verfahren zum Bedienen einer Bedienanordnung (3) von zumindest einem elektrischen Gerät (17, 18) in einem Kraftfahrzeug (1), bei welchem auf ein Bedienelement (4) bei dessen Betätigen in eine ausgehend von einer Grundstellung (14) des Bedienelements (4) betrachtet erste Betätigungsrichtung (12) eine Kraft durch eine Bedienperson ausgeübt wird, und mit einem Kraftsensor (11) die ausgeübte Kraft erfasst wird, wobei bei einem Überschreiten eines vorbestimmten ersten Kraft-Schwellwerts (A1) ein Schaltsignal der Bedienanordnung (3) zum Bedienen des elektrischen Geräts (17, 18) erzeugt wird,
wobei bei dem Überschreiten des ersten Kraft-Schwellwerts (A1) von einer Steuereinrichtung (7) der Bedienanordnung (3) ein Steuersignal an einen Aktuator (6) der Bedienanordnung (3) erzeugt wird und ein haptisches Signal zum haptischen Wahrnehmen durch die Bedienperson am Bedienelement (4) durch den Aktuator (6) erzeugt wird, wobei das Bedienelement (4) ein Wippschalter ist **dadurch gekennzeichnet, dass**
beim Überschreiten eines zweiten Kraft-Schwellwerts (A2), welcher in Richtung der ersten Betätigungsrichtung (12) des Bedienelements (4) liegt und größer als der erste Kraft-Schwellwert (A1) ist, die Steuereinrichtung (7) ein Steuersignal an den Aktuator (6) erzeugt und durch den Aktuator (6) ein zweites haptisches Signal zum haptischen Wahrnehmen durch die Bedienperson an dem Bedienelement (4) erzeugt wird, und
ein dritter Kraft-Schwellwert (A3), welcher in Richtung der ersten Betätigungsrichtung (12) liegt und der dritte Kraft-Schwellwert (A3) niedriger als der erste Kraft-Schwellwert (A1) ist, durch ein Betätigen des Bedienelements (4) ausgehend von der Position des Bedienelements (4) beim Erreichen des ersten Kraft-Schwellwerts (A1) in eine zur ersten Betätigungsrichtung (12) entgegengesetzte zweite Betätigungsrichtung (13) erreicht wird, und bei einem dann Unterschreiten des dritten Kraft-Schwellwerts (A3) die Steuereinrichtung (7) ein Steuersignal an den Aktuator (6) erzeugt und durch den Aktuator (6) ein drittes haptisches Signal zum haptischen Wahrnehmen durch die Bedienperson an dem Bedienelement (4) erzeugt wird und/oder
ein vierter Kraft-Schwellwert (A4), welcher in Richtung der ersten Betätigungsrichtung (12) liegt und niedriger als der zweite Kraft-Schwellwert (A2) ist, durch ein Betätigen des Bedienelements (4) ausgehend von der Position des Bedienelements (4) beim Erreichen des zweiten Kraft-Schwellwerts (A2) in eine zur ersten Betätigungsrichtung (12) entgegengesetzte zweite Betätigungsrichtung (13) erreicht wird, und bei einem dann Unterschreiten des vierten Kraft-Schwellwerts (A4) die Steuereinrichtung (7) ein Steuersignal an den Aktuator (6) erzeugt und durch den Aktuator (6) ein viertes haptisches Signal zum haptischen Wahrnehmen durch die Bedienperson an dem Bedienelement (4) erzeugt wird.

## Claims

1. Operator control arrangement (3) for operating at least one electrical apparatus (17, 18) in a motor vehicle (1), having an operator control element (4) to which a force can be applied by an operator when the operator control element (4) is activated in a first activation direction (12) viewed from a home position (14) of the operator control element (4), and with a force sensor (11) by means of which the force which can be applied can be sensed, wherein where a predetermined first force threshold value (A1) is exceeded the operator control arrangement (3) generates a switching signal for operating the electrical apparatus (17, 18), wherein the operator control arrangement (3) has an actuator (6), wherein when the first force threshold value (A1) is exceeded a control device (7) of the operator control arrangement (3) generates a control signal to the actuator (6), and the actuator (6) generates a first haptic signal to be haptically perceived at the operator control element (4) by the operator, wherein the operator control element (4) is a rocker switch,
**characterized in that**
the operator control arrangement (3) has, in the direction of the first activation direction (12) of the operator control element (4), at least one second predetermined force threshold value (A2) which is greater than the first force threshold value (A1), and when the second force threshold value (A2) is exceeded the control device (7) generates a control signal to the actuator (6), and the actuator (6) generates a second haptic signal to be haptically perceived at the operator control element (4) by the operator, and
the operator control arrangement (3) has, in the direction of the first activation direction (12), a third predetermined force threshold value (A3), wherein the third force threshold value (A3) is lower than the first force threshold value (A1), wherein the third force threshold value (A3) can be brought about by activating the operator control element (4) starting from the position of the operator control element (4) when the first force threshold value (A1) is achieved in a second activation direction (13) which is opposed to the first activation direction (12), and when the third force threshold value (A3) is then undershot the control device (7) generates a control signal to the actuator (6), and the actuator (6) generates a third haptic signal to be haptically perceived at the operator control element (4) by the operator, and/or
the operator control arrangement (3) has, in the direction of the first activation direction (12), a fourth predetermined force threshold value (A4), wherein the fourth force threshold value (A4) is lower than the second force threshold value (A2), wherein the fourth force threshold value (A4) can be brought about by activating the operator control element (4) starting from the position of the operator control element (4) when the second force threshold value (A2) is achieved in a second activation direction (13) which is opposite to the first activation direction (12), and when the fourth force threshold value (A4) is then undershot the control device (7) generates a control signal to the actuator (6), and the actuator (6) generates a fourth haptic signal to be haptically perceived at the operator control element (4) by the operator.

2. Operator control arrangement (3) according to Claim 1,
**characterized in that**
the operator control element (4) has at least one touch-sensitive sensor (5).

3. Operator control arrangement (3) according to one of the preceding claims,
**characterized in that**
the operator control arrangement (3) has, as an actuator (6), a vibration motor and/or a linear motor and/or an electromagnetic actuator and/or a piezoelectric actuator.

4. Operator control arrangement (3) according to one of the preceding claims,
**characterized in that**
the operator control element (4) can be activated in a second activation direction (13) viewed from the home position (14) of the operator control element (4), which second activation direction (13) is different from the first activation direction (12), in particular opposite.

5. Operator control arrangement (3) according to Claim 4,
**characterized in that**
the operator control arrangement (3) has, in the direction of the second activation direction (13) viewed from the home position (14) of the operator control element (4), a further predetermined force threshold value (B1), wherein when the further force threshold value (B1) is undershot the control device (7) of the operator control arrangement (3) generates a control signal to the actuator (6), and the actuator (6) generates a further haptic signal to be haptically perceived at the operator control element (4) by the operator.

6. Operator control arrangement (3) according to Claim 5,
**characterized in that**
the operator control arrangement (3) has, in the direction of the second activation direction (13) viewed from the home position (14) of the operator control element (4), yet another predetermined force threshold value (B2), wherein the yet another force threshold value (B2) is lower than the further force threshold value (B1), wherein the yet further force threshold value (B2) can be achieved by activating the operator control element (4) starting from the position of the operator control element (4) when the further force threshold value (B1) is achieved, and then activating the operator control element (4) in the first activation direction (12), and when the yet further force threshold value (B2) is then undershot the control device (7) generates a control signal to the actuator (6), and the actuator (6) generates yet another haptic signal to be haptically perceived at the operator control element (4) by the operator.

7. Operator control arrangement (3) according to one of the preceding claims,
**characterized in that**
the operator control arrangement (3) has at least one decoupling element (10) by means of which a movement of the operator control element (4) can be decoupled from a base (9) of the operator control arrangement (3).

8. Operator control arrangement (3) according to one of the preceding claims,
**characterized in that**
the operator control element (4) can be moved along a longitudinal axis (L) of the operator control arrangement (3) .

9. Operator control arrangement (3) according to one of Claims 1 to 5,
**characterized in that**
the operator control element (4) can be rotated about a rotational axis (D) of the operator control arrangement (3) .

10. Driver assistance system (16) having an operator control arrangement (3) according to one of Claims 1 to 9.

11. Driver assistance system (16) according to Claim 10,
**characterized in that**
the electrical appliance (17, 18) which is to be operated and/or a detected force and/or the force threshold value (A1, A2, A3, A4, B1, B2) can be displayed on a display device (15).

12. Motor vehicle (1) having a driver assistance system (16) according to one of Claims 13 to 11.

13. Method for operating an operator control arrangement (3) of at least one electrical apparatus (17, 18) in a motor vehicle (1), in which method a force is applied by an operator to an operator control element (4) when it is activated in a first activation direction (12) viewed from a home position (14) of the operator control element (4), and the applied force is detected with a force sensor (11), wherein when a predetermined first force threshold value (A1) is undershot a switching signal of the operator control arrangement (3) for operating the electrical apparatus (17, 18) is generated,
wherein when the first force threshold value (A1) is exceeded a control device (7) of the operator control arrangement (3) generates a control signal to an actuator (6) of the operator control arrangement (3), and the actuator (6) generates a haptic signal to be haptically perceived at the operator control element (4) by the operator, wherein the operator control element (4) is a rocker switch,
**characterized in that**
when a second force threshold value (A2) which occurs in the direction of the first activation direction (12) of the operator control element (4) and is higher than the first force threshold value (A1) is exceeded, the control device (7) generates a control signal to the actuator (6), and the actuator (6) generates a second haptic signal to be haptically perceived at the operator control element (4) by the operator, and
a third force threshold value (A3), which occurs in the direction of the first activation direction (12) and the third force threshold value (A3) is lower than the first force threshold value (A1), is achieved by activating the operator control element (4) starting from the position of the operator control element (4) when the first force threshold value (A1) is achieved, in a second activation direction (13) which is opposite to the first activation direction (12), and when the third force threshold value (A3) is then undershot the control signal (7) generates a control signal to the actuator (6), and the actuator (6) generates a third haptic signal to be haptically perceived at the operator control element (4) by the operator, and/or
a fourth force threshold value (A4), which occurs in the direction of the first activation direction (12) and is lower than the second force threshold value (A2), is achieved by activating the operator control element (4) starting from the position of the operator control element (4) when the second force threshold value (A2) is achieved, in a second activation direction (13) which is opposite the first activation direction (12), and when the fourth force threshold value (A4) is then undershot the control device (7) generates a control signal to the actuator (6), and the actuator (6) generates a fourth haptic signal to be haptically perceived at the operator control element (4) by the operator.

## Revendications

1. Dispositif de commande (3) destiné à commander au moins un appareil électrique (17, 18) dans un véhicule automobile (1), comprenant un élément de commande (4) sur lequel une force peut être exercée par un opérateur lors de l'actionnement de l'élément de commande (4) à partir d'une position de base (14) de l'élément de commande (4), vue dans une première direction d'actionnement (12), et comprenant un capteur de force (11) au moyen duquel la force pouvant être exercée peut être détectée, dans lequel, lorsqu'une première valeur de seuil de force (A1) prédéterminée est dépassée, le dispositif de commande (3) génère un signal de commutation destiné à commander l'appareil électrique (17, 18), dans lequel le dispositif de commande (3) comporte un actionneur (6), dans lequel, lorsque la première valeur de seuil de force (A1) est dépassée, un moyen de commande (7) du dispositif de commande (3) génère un signal de commande sur l'actionneur (6) et un premier signal haptique est généré par l'actionneur (6) à des fins de perception haptique par l'opérateur sur l'élément de commande (4), dans lequel l'élément de commande (4) est un commutateur à bascule,
**caractérisé en ce que** le dispositif de commande (3) présente, dans la direction de la première direction d'actionnement (12) de l'élément de commande (4), au moins une deuxième valeur de seuil de force (A2) prédéterminée qui est supérieure à la première valeur de seuil de force (A1), et lorsque la deuxième valeur de seuil de force (A2) est dépassée, le moyen de commande (7) génère un signal de commande sur l'actionneur (6) et un deuxième signal haptique est généré par l'actionneur (6) à des fins de perception haptique par l'opérateur sur l'élément de commande (4), et
le dispositif de commande (3) présente, dans la direction de la première direction d'actionnement (12), une troisième valeur de seuil de force (A3) prédéterminée, dans lequel la troisième valeur de seuil de force (A3) est inférieure à la première valeur de seuil de force (A1), dans lequel la troisième valeur de seuil de force (A3) peut être atteinte par un actionnement de l'élément de commande (4) à partir de la position de l'élément de commande (4) lorsque la première valeur de seuil de force (A1) est atteinte dans une deuxième direction d'actionnement (13) opposée à la première direction d'actionnement (12), et lorsque la troisième valeur de seuil de force (A3) est ensuite franchie en sens décroissant, le moyen de commande (7) génère un signal de commande sur l'actionneur (6) et un troisième signal haptique est généré par l'actionneur (6) à des fins de perception haptique par l'opérateur sur l'élément de commande (4), et/ou
le dispositif de commande (3) présente une quatrième valeur de seuil de force (A4) prédéterminée dans la direction de la première direction d'actionnement (12), dans lequel la quatrième valeur de seuil de force (A4) est inférieure à la deuxième valeur de seuil de force (A2), dans lequel la quatrième valeur de seuil de force (A4) peut être atteinte par un actionnement de l'élément de commande (4) à partir de la position de l'élément de commande (4) lorsque la deuxième valeur de seuil de force (A2) est atteinte dans une deuxième direction d'actionnement (13) opposée à la première direction d'actionnement (12), et lorsque la quatrième valeur de seuil de force (A4) est ensuite franchie en sens décroissant, le moyen de commande (7) génère un signal de commande sur l'actionneur (6) et un quatrième signal haptique est généré par l'actionneur (6) à des fins de perception haptique par l'opérateur sur l'élément de commande (4).

2. Dispositif de commande (3) selon la revendication 1,
**caractérisé en ce que** l'élément de commande (4) comporte au moins un capteur tactile (5).

3. Dispositif de commande (3) selon l'une des revendications précédentes,
**caractérisé en ce que** le dispositif de commande (3) comporte en tant qu'actionneur (6) un moteur de vibrations et/ou un moteur linéaire et/ou un actionneur électromagnétique et/ou un actionneur piézoélectrique.

4. Dispositif de commande (3) selon l'une des revendications précédentes,
**caractérisé en ce que** l'élément de commande (4) peut être actionné à partir de la position de base (14) de l'élément de commande (4) dans une deuxième direction d'actionnement (13) qui est différente de la première direction d'actionnement (12), en particulier opposée à celle-ci.

5. Dispositif de commande (3) selon la revendication 4,
**caractérisé en ce que** le dispositif de commande (3) présente une autre valeur de seuil de force (B1) prédéterminée à partir de la position de base (14) de l'élément de commande (4), vu dans la direction de la deuxième direction d'actionnement (13), dans lequel, lorsque l'autre valeur de seuil de force (B1) est dépassée, le moyen de commande (7) du dispositif de commande (3) génère un signal de commande sur l'actionneur (6) et un autre signal haptique est généré par l'actionneur (6) à des fins de perception haptique par l'opérateur sur l'élément de commande (4).

6. Dispositif de commande (3) selon la revendication 5,
**caractérisé en ce que** le dispositif de commande (3) présente encore une autre valeur de seuil de force (B2) prédéterminée à partir de la position de base (14) de l'élément de commande (4) vu dans la direction de la deuxième direction d'actionnement (13), dans lequel ladite encore autre valeur de seuil de force (B2) est inférieure à l'autre valeur de seuil de force (B1), dans lequel ladite encore autre valeur de seuil de force (B2) peut être atteinte par un actionnement de l'élément de commande (4) à partir de la position de l'élément de commande (4) lorsque l'autre valeur de seuil de force (B1) est atteinte et ensuite par un actionnement de l'élément de commande (4) dans la première direction d'actionnement (12), et lorsque ladite encore autre valeur de seuil de force (B2) est ensuite franchie en sens décroissant, le moyen de commande (7) génère un signal de commande sur l'actionneur (6) et encore un autre signal haptique est généré par l'actionneur (6) à des fins de perception haptique par l'opérateur sur l'élément de commande (4).

7. Dispositif de commande (3) selon l'une des revendications précédentes,
**caractérisé en ce que** le dispositif de commande (3) comporte au moins un élément de découplage (10) au moyen duquel un mouvement de l'élément de commande (4) peut être découplé d'une base (9) du dispositif de commande (3) .

8. Dispositif de commande (3) selon l'une des revendications précédentes,
**caractérisé en ce que** l'élément de commande (4) peut être déplacé le long d'un axe longitudinal (L) du dispositif de commande (3).

9. Dispositif de commande (3) selon l'une des revendications 1 à 5,
**caractérisé en ce que** l'élément de commande (4) peut tourner autour d'un axe de rotation (D) du dispositif de commande (3).

10. Système d'aide à la conduite (16) comprenant un dispositif de commande (3) selon l'une des revendications 1 à 9.

11. Système d'aide à la conduite (16) selon la revendication 10,
**caractérisé en ce que** l'appareil électrique (17, 18) à commander et/ou une force détectée et/ou la valeur de seuil de force (A1, A2, A3, A4, B1, B2) peuvent être affichés sur un dispositif d'affichage (15) du système d'aide à la conduite (16).

12. Véhicule automobile (1) comprenant un système d'aide à la conduite (16) selon l'une des revendications 13 à 11.

13. Procédé destiné à commander un dispositif de commande (3) d'au moins un appareil électrique (17, 18) dans un véhicule automobile (1), dans lequel une force est exercée par un opérateur sur un élément de commande (4) lorsque celui-ci est actionné dans une première direction d'actionnement (12), vue à partir d'une position de base (14) de l'élément de commande (4), et la force exercée est détectée au moyen d'un capteur de force (11), dans lequel, lorsqu'une première valeur de seuil de force (A1) prédéterminée est dépassée, un signal de commutation du dispositif de commande (3) destiné à commander l'appareil électrique (17, 18) est généré, dans lequel, lorsque la première valeur de seuil de force (A1) est dépassée, un signal de commande est généré par un moyen de commande (7) du dispositif de commande (3) sur un actionneur (6) du dispositif de commande (3) et un signal haptique est généré par l'actionneur (6) à des fins de perception haptique par l'opérateur sur l'élément de commande (4), dans lequel l'élément de commande (4) est un commutateur à bascule,
**caractérisé en ce que**, lorsqu'une deuxième valeur de seuil de force (A2), qui se situe dans la direction de la première direction d'actionnement (12) de l'élément de commande (4) et qui est supérieure à la première valeur de seuil de force (A1), est dépassée, le moyen de commande (7) génère un signal de commande sur l'actionneur (6) et un deuxième signal haptique est généré par l'actionneur (6) à des fins de perception haptique par l'opérateur sur l'élément de commande (4), et
une troisième valeur de seuil de force (A3), qui se situe dans la direction de la première direction d'actionnement (12), la troisième valeur de seuil de force (A3) étant inférieure à la première valeur de seuil de force (A1), est atteinte par un actionnement de l'élément de commande (4) à partir de la position de l'élément de commande (4) lorsque la première valeur de seuil de force (A1) est atteinte dans une deuxième direction d'actionnement (13) opposée à la première direction d'actionnement (12), et lorsque la troisième valeur de seuil de force (A3) est ensuite franchie en sens décroissant, le moyen de commande (7) génère un signal de commande sur l'actionneur (6) et un troisième signal haptique est généré par l'actionneur (6) à des fins de perception haptique par l'opérateur sur l'élément de commande (4) et/ou
une quatrième valeur de seuil de force (A4), qui se situe dans la direction de la première direction d'actionnement (12) et qui est inférieure à la deuxième valeur de seuil de force (A2), est atteinte par un actionnement de l'élément de commande (4) à partir de la position de l'élément de commande (4) lorsque la deuxième valeur de seuil de force (A2) est atteinte dans une deuxième direction d'actionnement (13) opposée à la première direction d'actionnement (12), et lorsque la quatrième valeur de seuil de force (A4) est ensuite franchie en sens décroissant, le moyen de commande (7) génère un signal de commande sur l'actionneur (6) et un quatrième signal haptique est généré par l'actionneur (6) à des fins de perception haptique par l'opérateur sur l'élément de commande (4).
